**Europäisches Patentamt**

**European Patent Office**

**Office européen des brevets**

(19)

(11) **EP 1 533 907 A1**

(12) **DEMANDE DE BREVET EUROPEEN**

(43) Date de publication:
**25.05.2005 Bulletin 2005/21**

(51) Int Cl.⁷: **H03M 5/12**

(21) Numéro de dépôt: **04364070.5**

(22) Date de dépôt: **19.11.2004**

(84) Etats contractants désignés:
**AT BE BG CH CY CZ DE DK EE ES FI FR GB GR HU IE IS IT LI LU MC NL PL PT RO SE SI SK TR**
Etats d'extension désignés:
**AL HR LT LV MK YU**

(30) Priorité: **21.06.2004 FR 0406746**
**21.11.2003 FR 0313689**

(71) Demandeur: **ATMEL NANTES SA**
**44306 Nantes Cédex 3 (FR)**

(72) Inventeurs:
• **Fonteneau, Eric**
**44240 Sucé sur Erdre (FR)**
• **Klinger, Virginie**
**44000 Nantes (FR)**

(74) Mandataire: **Bioret, Ludovic**
**Cabinet Vidon**
**16 B, rue Jouanet - B.P. 90333,**
**Technopole Atalante,**
**35703 Rennes Cedex 07 (FR)**

(54) **Procédé et circuit électronique de décodage des trames asynchrones biphase de longueur variable**

(57) Procédé et circuit électronique de décodage d'une trame asynchrone biphase dont la longueur n'est pas connue à l'avance, application, produit programme d'ordinateur et moyen de stockage correspondants.

L'invention concerne un procédé de décodage, par un circuit électronique, d'une trame asynchrone biphase portée par un signal de données encodé et comprenant L bits utiles suivis d'au moins un bit de stop. Selon l'invention, le procédé comprend une étape (22) de détection automatique de la longueur L en bits utiles de la trame de façon à décoder la totalité de la trame, la longueur L de la trame étant variable d'une trame à l'autre et telle que : $L_{min} \leq L \leq L_{max}$, avec $L_{max} = (L_{min} + k)$, où k est un nombre entier prédéterminé supérieur ou égal à 1.

Fig. 2

## Description

### 1. Domaine de l'invention

Le domaine de l'invention est celui du décodage de données numériques organisées en trames.

Plus précisément, l'invention concerne les décodeurs de trames de données asynchrones biphases, en particulier codées selon le code de Manchester.

L'invention peut trouver des applications dans tous les domaines utilisant des transmissions de type Manchester, comme celui du contrôle industriel ou des télécommunications, en particulier lorsqu'il est souhaitable de disposer de décodeurs simples et à coût réduit.

Par exemple, l'invention peut s'appliquer à la communication dans le domaine de l'éclairage, et notamment au décodage de trames asynchrones biphases conformes au protocole DALI (« Digital Adressable Lighting Interface » ou « Interface d'éclairage numérique adressable »). Ce dernier est un protocole standard (CEI 60929) de communication sur bus destiné à faire communiquer des appareils de lumière avec un contrôleur, avec simplicité (liaison deux fils), fiabilité (signaux numériques, codage Manchester) et interopérabilité (appareils de constructeurs différents).

### 2. Art antérieur

Il existe des méthodes de décodage de trames asynchrones biphases (typiquement des « trames Manchester »). Avec ces méthodes de décodage, la longueur L en bits utiles des trames est impérativement fixe et connue à l'avance du circuit de décodage. En effet, de façon classique, une trame asynchrone biphase comprend L bits utiles, précédés d'au moins un bit de démarrage et suivis d'au moins un bit de stop. Ainsi, par exemple, le protocole DALI prévoit que chaque trame est composée de 1 bit de démarrage, 16 bits utiles (bits de données) et 2 bits de stop.

A la connaissance des inventeurs, il n'existe à ce jour aucune solution technique pour effectuer un décodage dans un nouveau contexte où la longueur L en bits utiles serait variable d'une trame à l'autre et pas connue à l'avance du circuit de décodage.

Il n'existe pas non plus, à la connaissance des inventeurs, de solution technique permettant au décodeur de changer automatiquement de mode de fonctionnement, et notamment de passer d'un mode normal à un mode de test.

Par ailleurs, le codage de Manchester est une technique connue depuis longtemps et appliquée dans de nombreux domaines. Il existe plusieurs méthodes pour récupérer l'horloge correspondante dans un récepteur, et en particulier l'utilisation d'une boucle à verrouillage de phase (encore appelée PLL, de l'anglais « Phase-Locked Loop ») ou d'une horloge précise. Cependant, aucune de ces solutions de synchronisation n'est satisfaisante.

Avec une boucle à verrouillage de phase, la phase du signal de sortie est verrouillée sur celle du signal d'entrée, ce qui force la fréquence du signal de sortie à se verrouiller sur la fréquence du signal d'entrée, permettant un asservissement de fréquence, donc une synchronisation. Un inconvénient majeur de cette technique est que durant l'étape de verrouillage de phase qui va permettre la synchronisation, les premières données transmises sont perdues. Un autre inconvénient de cette technique est qu'elle est coûteuse et relativement complexe à mettre en oeuvre, du fait notamment de la présence d'une boucle à verrouillage de phase.

Pour d'autres systèmes de transmission à distance, il est nécessaire d'utiliser une horloge précise afin de décoder de manière fiable les données reçues. Un inconvénient majeur de cette technique est qu'elle impose de connaître au niveau du récepteur la vitesse de la transmission (ou « baud rate »). Par ailleurs, elle nécessite de disposer d'une horloge locale précise, aussi bien au niveau de l'émetteur qu'au niveau du récepteur, ce qui rend cette technique plus coûteuse et complexe à mettre en oeuvre.

### 3. Objectifs de l'invention

L'invention a notamment pour objectif de pallier ces différents inconvénients de l'état de la technique.

Plus précisément, l'un des objectifs de la présente invention est de fournir une technique de décodage d'un signal de données asynchrone biphase dans le nouveau contexte précité où la longueur L en bits utiles peut varier d'une trame à l'autre et n'est pas connue à l'avance du circuit de décodage.

L'invention a également pour objectif de fournir une telle technique qui soit simple et peu coûteuse.

Un autre objectif de l'invention est de fournir une telle technique ne nécessitant ni boucle à verrouillage de phase ni horloge précise.

### 4. Caractéristiques essentielles de l'invention

Ces différents objectifs, ainsi que d'autres qui apparaîtront par la suite, sont atteints selon l'invention à l'aide d'un procédé de décodage, par un circuit électronique, d'une trame asynchrone biphase portée par un signal de données encodé et comprenant L bits utiles suivis d'au moins un bit de stop. Selon l'invention, le procédé comprend une étape de détection automatique de la longueur L en bits utiles de la trame de façon à décoder la totalité de la trame, la longueur L de la trame étant variable d'une trame à l'autre et telle que : $L_{min} \le L \le L_{max}$, avec $L_{max} = (L_{min} + k)$, où k est un nombre entier prédéterminé supérieur ou égal à 1.

Le principe général de l'invention consiste donc à se placer dans un nouveau contexte où les trames émises successivement n'ont pas toutes la même longueur en bits utiles et où le décodeur ne reçoit pas d'information l'informant à l'avance du nombre exact de bits utiles compris dans chaque trame transmis, et à permettre au décodeur de détecter automatiquement la longueur L de chaque trame. Ceci évite l'envoi préalable au décodeur d'informations sur la longueur L de chaque trame. Ainsi, l'invention s'avère particulièrement simple et efficace.

Différentes applications peuvent être envisagées dans ce nouveau contexte.

Dans un mode de réalisation particulier de l'invention, ledit procédé comprend en outre une étape de sélection d'un mode de fonctionnement du circuit électronique parmi au moins deux modes de fonctionnement possibles, en fonction de la longueur L détectée.

Avantageusement, lesdits au moins deux modes de fonctionnement possibles sont un mode normal et un mode de test.

De façon avantageuse, ladite étape de sélection est telle que : si la longueur L détectée est égale à $L_{min}$, le mode normal est sélectionné ; si la longueur L détectée est égale à $L_{max}$, le mode de test est sélectionné.

Avantageusement, quand le mode de test est sélectionné, le circuit électronique traite comme une trame de test au moins une trame reçue après la trame dont la longueur L a été détectée.

Préférentiellement, l'étape de détection automatique de la longueur L de la trame comprend elle-même les étapes successives suivantes :

a) détection d'une éventuelle transition dans une portion du signal portant le bit de rang $(L_{min} + p)$, avec p une variable de type nombre entier qui est initialisée à 1 ;
b) si aucune transition n'est détectée, le bit de rang $(L_{min} + p)$ est estimé comme un bit de stop et la trame est traitée comme une trame de $(L_{min} + (p-1))$ bits utiles ;
c) si une transition est détectée, le bit de rang $(L_{min} + p)$ est estimé comme un bit utile et :

c-1) si $(L_{min} + p) = L_{max}$, la trame est traitée comme une trame de $(L_{min} + p)$ bits utiles ;
c-2) si $(L_{min} + p) < L_{max}$, on revient à l'étape a) en ayant préalablement incrémenté p de un pour traiter une portion du signal portant le bit suivant.

De façon préférentielle, l'étape a) comprend elle-même une étape de fenêtrage, limitant à une fenêtre temporelle déterminée la détection d'une éventuelle transition dans la portion du signal portant le bit de rang $(L_{min} + p)$.

Dans un mode de réalisation préférentiel de l'invention, l'étape de fenêtrage met en oeuvre un compteur alimenté par une horloge interne audit circuit, et qui est incrémenté depuis zéro jusqu'à une valeur maximale déterminée, puis décrémenté depuis la valeur maximale déterminée jusqu'à zéro. En outre, ladite fenêtre temporelle déterminée est définie comme un intervalle de temps pendant lequel la valeur courante du compteur est supérieure ou égale à un seuil prédéterminé.

Selon une caractéristique avantageuse, ladite valeur maximale déterminée du compteur est une valeur prédéterminée fonction d'une fréquence d'émission et d'un taux de transfert du signal de données.

Selon une variante avantageuse, ladite valeur maximale déterminée du compteur est lue dans un registre ayant préalablement mémorisé le contenu du compteur lors de la détection d'une transition dans la portion du signal de données portant le bit de rang $L_{min}$.

De façon avantageuse, ledit seuil prédéterminé est égal à la moitié de ladite valeur maximale déterminée du compteur, de sorte que ladite fenêtre temporelle couvre environ 50% d'un temps binaire.

Avantageusement, dans le cas où ladite trame comprend L bits utiles suivis d'un premier et un second bit de stop, alors l'étape de détection automatique de la longueur de ladite trame comprend en outre une première étape de vérification de la décision, prise lors de l'étape b), de traiter la trame comme une trame de $(L_{min} + (p-1))$ bits utiles, ladite première étape de vérification consistant à vérifier que le bit de rang $(L_{min} + (p+1))$ est un second bit de stop.

Avantageusement, l'étape de détection automatique de la longueur de la trame comprend en outre une seconde étape de vérification de la décision, prise lors de l'étape c-1), de traiter la trame comme une trame de $(L_{min} + p)$ bits utiles, ladite seconde étape de vérification consistant à vérifier que le bit de rang $(L_{min} + (p+1))$ est un bit de stop.

Dans un mode de réalisation particulier de l'invention, $L_{max} = (L_{min} + 1)$, et en ce que l'étape de traitement du bit de rang $L_{max}$ comprend elle-même les étapes successives suivantes :

a') détection d'une éventuelle transition dans une portion du signal portant le bit de rang $L_{max}$ ;
b') si aucune transition n'est détectée, le bit de rang $L_{max}$ est estimé comme un bit de stop et la trame est traitée comme une trame de $L_{min}$ bits utiles ;
c') si une transition est détectée, le bit de rang $L_{max}$ est estimé comme un bit utile et la trame est traitée comme une trame de $L_{max}$ bits utiles.

Dans un mode de réalisation avantageux de l'invention, ledit signal de données est encodé selon un codage de Manchester.

L'invention concerne également un produit programme d'ordinateur, comprenant des instructions de code de programme pour l'exécution des étapes du procédé de décodage selon l'invention, lorsque ledit programme est exécuté sur un ordinateur.

L'invention concerne aussi un moyen de stockage, éventuellement totalement ou partiellement amovible, lisible par un ordinateur, stockant un jeu d'instructions exécutables par ledit ordinateur pour mettre en oeuvre le procédé de décodage selon l'invention.

L'invention concerne encore un circuit électronique de décodage d'une trame asynchrone biphase portée par un signal de données encodé et comprenant L bits utiles suivis d'au moins un bit de stop, ledit circuit comprenant des moyens de détection automatique de la longueur L en bits utiles de la trame de façon à décoder la totalité de la trame, la longueur L de la trame étant variable d'une trame à l'autre et telle que : $L_{min} \leq L \leq L_{max}$, avec $L_{max} = (L_{min} + k)$, où k est un nombre entier prédéterminé supérieur ou égal à 1.

Avantageusement, ledit circuit comprend en outre des moyens de sélection d'un mode de fonctionnement du circuit électronique parmi au moins deux modes de fonctionnement possibles, en fonction de la longueur L détectée.

L'invention concerne également un dispositif de contrôle d'au moins un équipement, ce dispositif comprenant un circuit électronique de décodage selon l'invention.

Avantageusement, l'équipement contrôlé est un équipement d'éclairage.

### 5. Liste des figures

D'autres caractéristiques et avantages de l'invention apparaîtront à la lecture de la description suivante d'un mode de réalisation préférentiel de l'invention, donné à titre d'exemple indicatif et non limitatif, et des dessins annexés, dans lesquels :

- la figure 1 présente un schéma général d'un décodeur d'une trame encodée selon le principe de Manchester ;
- la figure 2 présente un organigramme d'un mode de réalisation particulier du procédé selon l'invention ;
- la figure 3 décrit le fonctionnement du décodeur de la figure 1, selon l'invention, sous la forme d'un schéma bloc ;
- la figure 4 présente une machine d'état détaillant un mode de réalisation particulier de l'étape de détection automatique de la longueur d'une trame, apparaissant sur l'organigramme de la figure 2 ;
- la figure 5 présente un chronogramme des différents signaux d'entrée/sortie et des signaux intermédiaires du schéma de la figure 3, dans le cas d'une trame comprenant 17 bits utiles et deux bits de stop ;
- la figure 6 présente un chronogramme des différents signaux d'entrée/sortie et des signaux intermédiaires du schéma de la figure 3, dans le cas d'une trame comprenant 16 bits utiles et un bit de stop ;
- la figure 7 présente en détail un exemple de détection d'un 17$^{ème}$ bit utile ;
- la figure 8 présente en détail la détection d'un premier et un second bits de stop.

### 6. Description d'un mode de réalisation de l'invention

Le principe général de l'invention repose sur un circuit électronique de décodage de trame asynchrone biphasé permettant de récupérer en sortie les données transmises et leur horloge de transmission, quelle que soit la longueur en bits utiles de chaque trame.

L'invention utilise un simple compteur et ne nécessite pas d'horloge interne précise ou de boucle à verrouillage de phase. Ce circuit électronique peut en particulier s'adapter automatiquement à une vitesse de transmission quelconque et variable, même s'il ne connaît pas précisément l'horloge interne. Il suffit pour cela de mettre en oeuvre un compteur suffisamment profond pour s'adapter à une vitesse de transmission relativement basse, et une l'horloge locale suffisamment rapide par rapport à une vitesse de transmission plus élevée.

On considère selon l'invention que la trame de données reçue au niveau du décodeur est de type asynchrone car elle est constituée d'une suite d'éléments binaires asynchrones du récepteur. Elle est également de type biphasé car les bits de données ne sont pas encodés par des états mais par des bits de transition. Ce codage est connu sous le nom de codage Manchester.

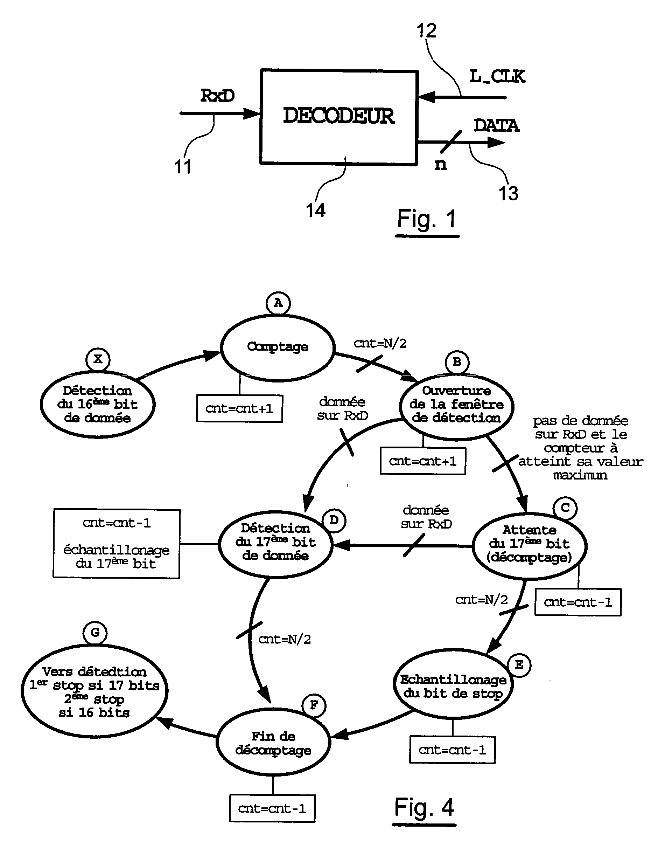

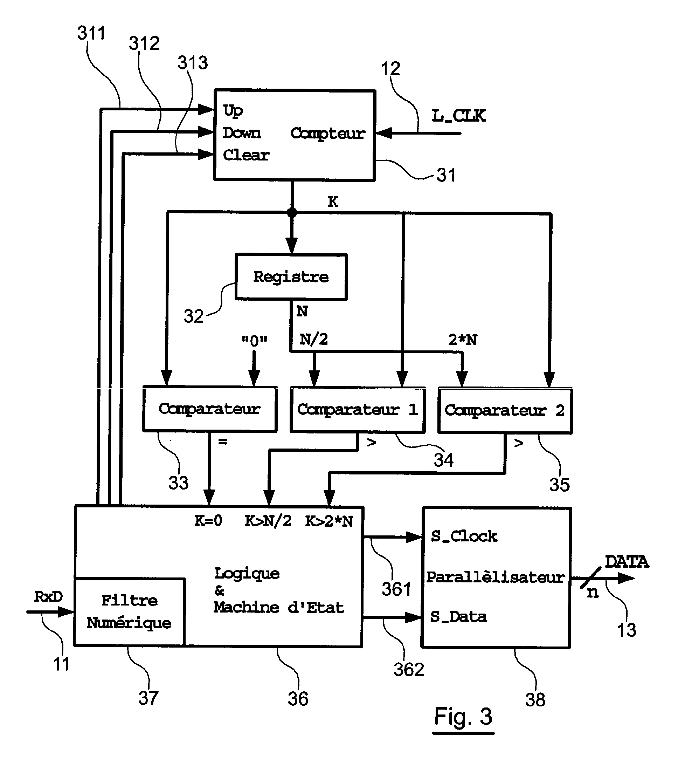

On présente, en relation avec la **figure 1,** les entrées et les sorties du décodeur 14.

Ce décodeur 14 possède deux entrées, la première 11 sur laquelle sont envoyées les trames asynchrones biphases (notées RxD sur la figure) et la seconde 12 correspondant à l'entrée de l'horloge locale (L_CLK sur la figure), encore appelée horloge interne. Dans le mode de réalisation décrit, l'horloge locale peut être de fréquence imprécise, mais supérieure à 16 fois le débit de la donnée à décoder.

Ce décodeur 14 possède également une sortie 13 qui permet de retrouver les données décodées DATA, mises en parallèle sur une largeur de *n* bits, le nombre *n* variant suivant l'application.

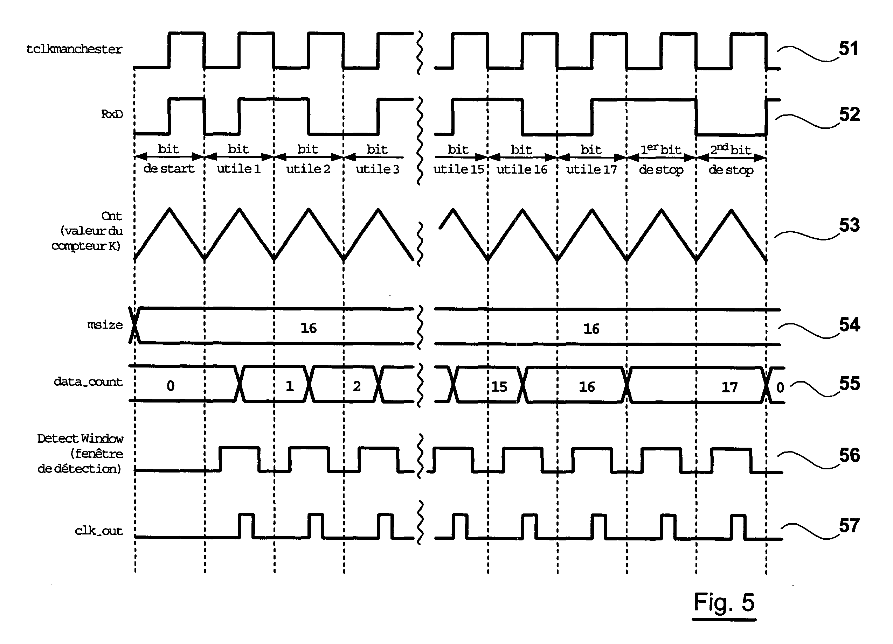

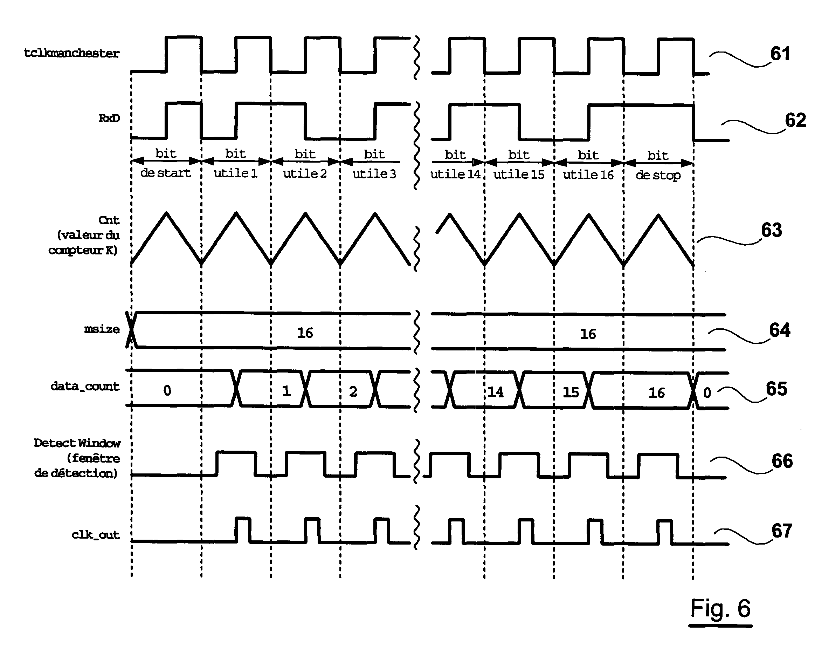

Le signal transmis est organisé en trames. Les trames asynchrones biphases reçues sur l'entrée RxD 11 du décodeur 14 se composent d'un bit de démarrage (aussi appelé bit de « start »), se poursuivent par des bits utiles (aussi appelés bits de données) et se terminent par un ou plusieurs bit de stop (aussi appelés bits d'arrêt). Le bit de démarrage et les bits utiles ne sont pas encodés par des états mais par des transitions, comme illustré sur les figures 5 et 6. En revanche, les bits de stop sont encodés par des états (c'est-à-dire par des niveaux).

Ainsi, selon le codage de Manchester, les bits utiles égaux à '1' sont codés par des fronts montants et les bits utiles égaux à '0' sont codés par des fronts descendants. Le bit de démarrage est également encodé selon le principe de Manchester.

Il est bien entendu que l'invention présentée s'applique également à tout autre type de codage où les bits utiles sont encodés par des transitions et non par des états. On pourra ainsi, dans un autre mode de réalisation, coder les bits utiles égaux à '1' par des fronts descendants et les bits utiles égaux à '0' par des fronts montants.

En l'absence de transmission ou entre les données, on reste dans un état inactif, durant lequel il n'y a aucune transition.

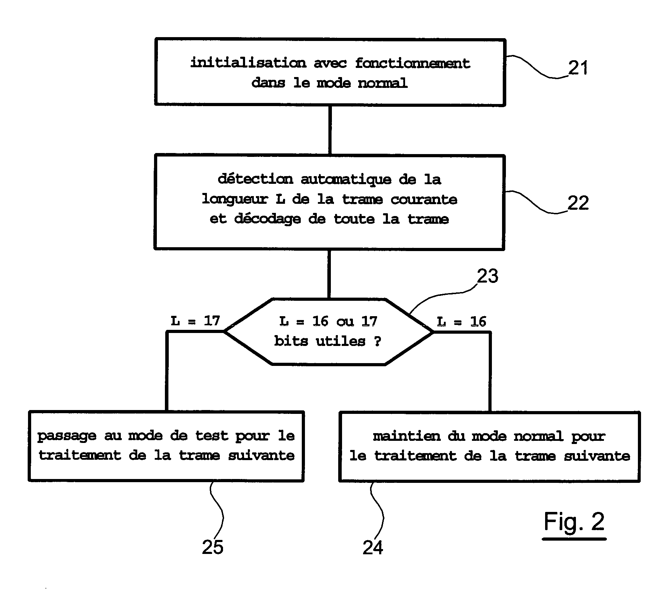

On présente maintenant, en relation avec l'organigramme de la **figure 2**, un mode de réalisation particulier du procédé selon l'invention.

Le décodeur est tout d'abord initialisé dans un mode de fonctionnement normal (étape 21). Puis, le décodeur détecte de façon automatique la longueur L en bits utiles de la trame courante et effectue le décodage de la totalité de cette trame courante (étape 22). Si la longueur L détectée prend une première valeur (par exemple 16, correspondant à une « trame DALI classique » c'est-à-dire conforme au protocole DALI) (premier cas de sortie de l'étape 23), le décodeur maintient son mode de fonctionnement normal pour le traitement d'une ou plusieurs trames suivantes (étape 24). Si la longueur L détectée prend une seconde valeur (par exemple 17, correspondant à une « trame DALI modifiée », non prévue dans le protocole DALI tel que spécifié aujourd'hui) (second cas de sortie de l'étape 23), le décodeur passe du mode de fonctionnement normal à un mode de test pour le traitement d'une ou plusieurs trames suivantes (étape 25).

Ainsi, à travers cet exemple, l'invention permet d'étendre le protocole DALI actuel en introduisant l'utilisation d'un second type de trames, comprenant 17 bits utiles au lieu de 16. Ceci permet au bus DALI de transmettre des informations spécifiques différentes d'une transmission DALI standard, comme par exemple des données spécifiques de test. Si une trame transmise comprend 16 bits utiles, alors le décodeur va détecter une trame DALI standard, et la traiter comme quelle. Par contre, si une trame transmise comprend 17 bits utiles, les 16 premiers bits utiles seront traités comme des informations standard et le 17ème bit va permettre d'indiquer au décodeur que les trames suivantes ne seront pas des trames DALI standard mais des trames de test. Ces trames de test pourront ainsi être traitées en conséquence.

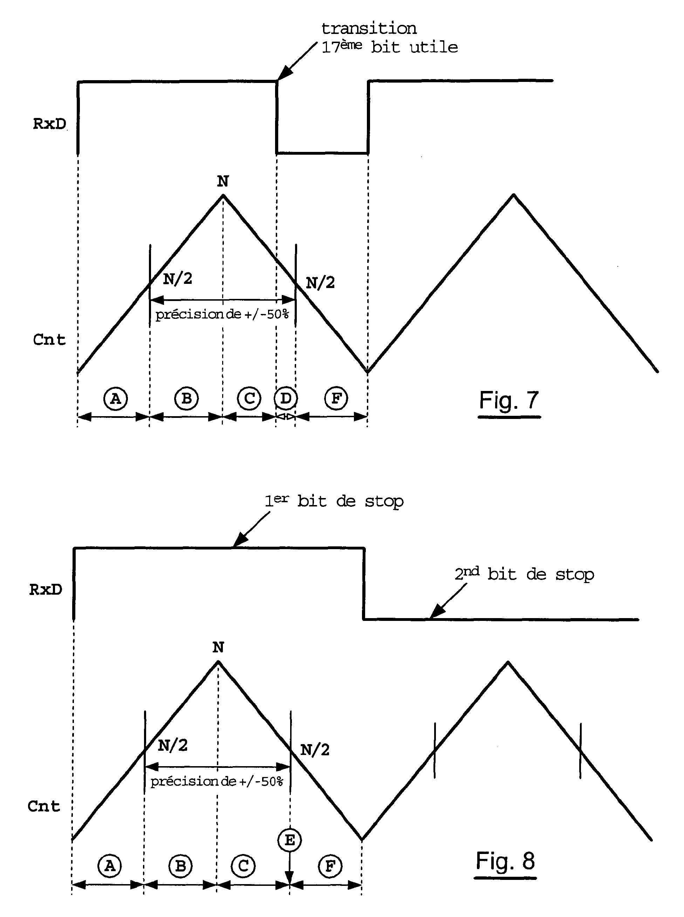

On présente plus précisément, en relation avec la **figure 3**, le schéma bloc du décodeur 14 déjà discuté ci-dessus en relation avec la figure 1.

Dans un mode préférentiel de réalisation, ce décodeur 14 est composé de :

- un compteur 31, pouvant être incrémenté ou décrémenté ;
- un registre 32 servant à stocker la valeur du compteur 31 à un instant donné (par la suite, la valeur du registre est notée « N » et la valeur du compteur est notée « K » ou « cnt ») ;

- un comparateur 33 comparant la valeur du compteur 31 à zéro, appelé comparateur à zéro ;
- deux autres comparateurs appelés premier comparateur 34 et deuxième comparateur 35 ;
- un bloc « Logique et Machine d'Etat » 36 ;
- un filtre numérique 37 ; et
- un parallélisateur 38.

En général, la largeur du compteur 31 et celle du registre 32 sont données par le rapport entre le « baud rate » du signal de données et la valeur de l'horloge locale. Par exemple, avec une donnée à 1200 bauds et une horloge locale à 1MHz, la capacité de comptage doit être supérieure à $\frac{10^6}{2400}$, soit 416, ce qui définit un compteur à 9 bits. Pour permettre d'absorber les tolérances sur la donnée et sur l'horloge locale ($\pm$ 10% par exemple) et mettre en place la détection d'erreurs de trame, l'utilisation d'un compteur d'au moins 10 bits est recommandée.

Le filtre numérique 37 à l'entrée du montage vise à améliorer le décodage en permettant la réjection des parasites, évitant ainsi au décodeur 14 de confondre un parasite avec une transition. Pour cela, on peut prendre en compte plusieurs échantillons successifs de signal, par exemple trois. En fonction du niveau de ces trois échantillons successifs, on pourra décider s'ils correspondent à une transition (front montant ou front descendant) ou à un parasite.

Le parallélisateur 38 permet de reconstruire le signal de données décodées 13 DATA, constitué des données décodées en parallèle sur une largeur *n* bits, où le nombre *n* dépend de l'application.

Dans seul souci de simplification, on se place dans la suite de la description dans le cas où le décodeur reçoit des trames comprenant chacune un bit de démarrage, 16 ou 17 bits utiles et un ou deux bits de stop. En d'autres termes, dans cet exemple, le décodeur reçoit deux types de trames : des « trames DALI classiques » (16 bits utiles) et des « trames DALI modifiées » (17 bits utiles).

Le choix du nombre de bit de stop compris dans une trame donnée se fait par exemple en fonction du taux de transfert, c'est-à-dire de la vitesse de traitement de la trame par rapport au temps du ou des stop bits.

Il est clair cependant que l'invention peut être mise en oeuvre avec d'autres structures de trame. D'une façon générale, le décodeur selon l'invention est capable de traiter des trames possédant une longueur L en bits utiles qui est variable d'une trame à l'autre et telle que : $L_{min} \le L \le L_{max}$, avec $L_{max} = (L_{min} + k)$, où k est un nombre entier prédéterminé supérieur ou égal à 1.

On présente ci-après successivement les deux phases de traitement d'une trame par le décodeur, dans le mode de fonctionnement normal (voir discussion ci-dessus). Dans la première phase, le décodeur traite le bit de démarrage et les 16 premiers bits utiles. Dans la seconde phase, le décodeur traite les bits suivants (éventuel 17ème bit utile, et bit(s) de stop).

Traitement du bit de démarrage et des 16 premiers bits utiles

Durant l'état inactif qui précède le bit de démarrage, le compteur 31 est maintenu à la valeur zéro. Le comparateur à zéro 33 comparant la sortie du compteur 31 à la valeur zéro est donc en position 'vrai', et cette information est transmise au bloc « Logique et Machine d'Etat » 36. Rien ne se passe : la ligne de transmission est dans un état inactif. Dans cette position, le compteur 31 est à zéro, sous l'action d'une commande de mise à zéro 313 (appelée « clear »).

Lors du premier front descendant (début du bit de démarrage), le compteur 31 reçoit une commande 311 (appelée « up ») du bloc « Logique et Machine d'Etat » 36, lançant une incrémentation du compteur jusqu'à la détection d'une nouvelle transition dans le signal de données (codant le bit de démarrage). La valeur courante K du compteur 31 est alors stockée dans le registre 32 (la valeur N du registre est égale à K). Quand il détecte cette transition, le bloc « Logique et Machine d'Etat » 36 envoie une commande de décrémentation 312 (appelée « down »), afin que le compteur 31 reparte dans l'autre sens.

Lorsque le comparateur à zéro 33 détecte que le compteur 31 a atteint la valeur zéro, ce dernier repart de nouveau dans le sens montant, sous l'action par exemple de la logique définie dans le bloc « Logique et Machine d'Etat » 36. A la prochaine transition (codant le premier bit utile), la nouvelle valeur du compteur 31 est mémorisée dans le registre 32 et le compteur 31 est de nouveau décrémenté jusqu'à zéro.

Ceci est répété pour chacun des bits utiles suivants, jusqu'au seizième. On peut alors assimiler la valeur de comptage en sortie du compteur à un signal en dents de scie, les pics de chacune des dents correspondant aux transitions dans le signal de données. C'est à partir de ces transitions que l'on va récupérer l'horloge de décodage et les données décodées.

Dans ce mode préférentiel de réalisation décrit, le circuit comprend également deux autres comparateurs 34 et 35 permettant d'améliorer les performances de décodage.

Le premier comparateur 34 permet de comparer la valeur K du compteur 31 à la valeur N du registre 32 divisée par deux (K > N/2 ?). Lorsque la valeur K du compteur 31 est supérieure à N/2, une fenêtre de détection est créée, autorisant la détection de transition dans cette fenêtre. Une telle fenêtre couvre environ 50% d'un temps binaire et est centrée sur la transition. Ce premier comparateur 34 permet donc d'améliorer la robustesse du système puisqu'il réduit la probabilité de fausse détection et interdit la détection sur les fronts inter-bits lorsque les bits consécutifs sont de même valeur.

Le deuxième comparateur 35 permet de comparer la valeur K du compteur 31 à la valeur N du registre 32 multipliée par deux (K > 2*N ?). Cette comparaison permet de détecter si on reçoit toujours des transitions, et donc si la transmission n'est pas interrompue. La robustesse du décodeur est donc de nouveau améliorée.

Finalement, dans ce mode de réalisation décrit, le bloc « Logique et Machine d'Etat » 36 va permettre de récupérer deux signaux, un signal d'horloge de décodage 361 et un signal de données décodées intermédiaire 362, appelés S_Clock et S_Data sur le schéma-bloc.

Ce bloc « Logique et Machine d'Etat » 36 intervient à différentes étapes au cours du décodage : il a pour rôle de détecter les changements de fronts sur le signal de données asynchrone biphasé à décoder, de compter le nombre de bits reçus suivant l'application et de gérer le compteur 31 et le registre 32 en tenant compte de la sortie des trois comparateurs 33, 34 et 35.

Traitement des bits suivants (éventuel 17ème bit utile, et bit(s) de stop)

Le traitement des bits suivants correspond à l'étape de détection automatique de la longueur d'une trame (référencée 22 sur l'organigramme de la figure 2).

On en présente désormais un mode de réalisation particulier, en relation avec la machine d'état de la **figure 4**.

Dans l'état « X », le décodeur détecte le 16ème bit utile (fin de la première phase de traitement décrite ci-dessus) puis passe dans l'état « A ».

Dans l'état « A », le décodeur incrémente le compteur 31 (cnt = cnt + 1). Lorsque la valeur cnt du compteur 31 devient supérieure à N/2, on passe dans l'état « B » où une fenêtre de détection est ouverte et l'incrémentation du compteur se poursuit.

On rappelle que N est égal à la valeur maximale du compteur, à l'instant où la transition codant le 16ème bit utile a été détectée. Dans une variante de réalisation de l'invention, on remplace N par une valeur maximale prédéterminée fonction d'une fréquence d'émission et d'un taux de transfert du signal de données.

A partir de l'état « B », si une transition est détectée dans le signal reçu (sur l'entrée RxD) avant que le compteur ait atteint la valeur maximale N, on passe à l'état « D », dans lequel le bit qui suit le 16ème bit utile est traité et échantillonné comme un 17ème bit utile. Par ailleurs, on commence la décrémentation du compteur.

A partir de l'état « D », lorsque la valeur cnt du compteur 31 devient inférieure à N/2, on passe dans l'état « F » où la fenêtre de détection est fermée et la décrémentation du compteur se poursuit.

A partir de l'état « B », si aucune transition n'est détectée dans le signal reçu avant que le compteur ait atteint la valeur maximale N, on passe à l'état « C », dans lequel on commence la décrémentation du compteur et on continue à attendre une éventuelle transition.

A partir de l'état « C », si une transition est détectée dans le signal reçu avant que le compteur ait atteint la valeur N/2, on passe à l'état« D » déjà discuté ci-dessus.

A partir de l'état « C », si la valeur cnt du compteur 31 devient inférieure à N/2 sans qu'aucune transition n'est été détectée dans le signal reçu, on passe dans l'état « E » où le bit qui suit le 16ème bit utile est traité et échantillonné comme un bit de stop. Puis, on passe à l'état « F » déjà discuté ci-dessus (fermeture de la fenêtre de détection et poursuite de la décrémentation du compteur).

A partir de l'état « F », on passe à l'état « G » pour le traitement du premier ou du second bit de stop, selon que le bit qui suit le 16ème bit utile est traité et échantillonné comme un 17ème bit utile (voir état « D ») ou un bit de stop (voir état « E »).

La **figure 7** présente en détail un exemple de détection d'un 17ème bit utile. On a représenté le signal reçu sur l'entrée RxD (ligne du haut), la valeur cnt du compteur (ligne du milieu), ainsi que les états successifs de la machine d'états (ligne du bas). Dans cet exemple, une transition est détectée alors que la valeur du compteur est comprise entre N et N/2. Le 17ème bit utile est ici pris en compte avant la descente du compteur à N/2. Les états successifs sont donc : « A », « B », « C », « D » et « F ».

La **figure 8** présente en détail la détection d'un premier et un second bits de stop. A nouveau, on a représenté le signal reçu sur l'entrée RxD (ligne du haut), la valeur cnt du compteur (ligne du milieu), ainsi que les états successifs de la machine d'états (ligne du bas). Dans cet exemple, aucune transition n'est détectée pendant la fenêtre de détection de la nature du bit qui suit le 16ème bit utile (c'est-à-dire ni pendant la phase ascendante du compteur, de N/2 à N, ni pendant la phase descendante, de N à N/2). Le premier bit de stop est ici pris en compte lorsque le compteur atteint N/2. Les états successifs sont donc : « A », « B », « C », « E » et « F ». La détection du second bit de stop est effectuée de la même façon que celle du premier bit de stop.

Les figures 5 et 6 permettent de visualiser plus facilement le fonctionnement du décodeur 14, en présentant chacun un chronogramme des différents signaux d'entrée/sortie et des signaux intermédiaires au décodeur (voir figure 3). La **figure 5** correspond au cas d'une trame comprenant 17 bits utiles et deux bits de stop. La **figure 6** correspond au cas d'une trame comprenant 16 bits utiles et un bit de stop.

Sur la première ligne 51, 61, on a représenté le signal d'horloge utilisé pour effectuer le codage (« tclkmanchester » ), et que l'on cherche à reconstituer dans le décodeur.

Sur la deuxième ligne 52, 62, on a représenté le signal reçu sur l'entrée du décodeur (« RxD »).

Sur la troisième ligne 53, 63, on a représenté la valeur courante du compteur (« cnt »).

Sur la quatrième ligne 54, 64, on a représenté le paramètre d'avancement de la machine d'état de réception Manchester (« msize »).

Sur la cinquième ligne 55, 65, on a représenté le nombre de données reçues (« data_count »).

Sur la sixième ligne 56, 66, on a représenté un signal représentant les fenêtres de détection (« Detect Window »).

Sur la septième ligne 57, 67, on a représenté l'horloge reconstituée (« clk_out »).

**Revendications**

1. Procédé de décodage, par un circuit électronique (14), d'une trame asynchrone biphasé portée par un signal de données encodé et comprenant L bits utiles suivis d'au moins un bit de stop, **caractérisé en ce qu'**il comprend une étape (22) de détection automatique de la longueur L en bits utiles de la trame de façon à décoder la totalité de la trame, la longueur L de la trame étant variable d'une trame à l'autre et telle que : $L_{min} \leq L \leq L_{max}$, avec $L_{max} = (L_{min} + k)$, où k est un nombre entier prédéterminé supérieur ou égal à 1.

2. Procédé selon la revendication 1, **caractérisé en ce qu'**il comprend en outre une étape (23, 24, 25) de sélection d'un mode de fonctionnement du circuit électronique parmi au moins deux modes de fonctionnement possibles, en fonction de la longueur L détectée.

3. Procédé selon la revendication 2, **caractérisé en ce que** lesdits au moins deux modes de fonctionnement possibles sont un mode normal et un mode de test.

4. Procédé selon la revendication 3, **caractérisé en ce que** ladite étape de sélection est telle que : si la longueur L détectée est égale à $L_{min}$, le mode normal est sélectionné ; si la longueur L détectée est égale à $L_{max}$, le mode de test est sélectionné.

5. Procédé selon l'une quelconque des revendications 3 et 4, **caractérisé en ce que**, quand le mode de test est sélectionné, le circuit électronique traite comme une trame de test au moins une trame reçue après la trame dont la longueur L a été détectée.

6. Procédé selon l'une quelconque des revendications 1 à 5, **caractérisé en ce que** l'étape de détection automatique de la longueur L de la trame comprend elle-même les étapes successives suivantes :

a) détection d'une éventuelle transition dans une portion du signal portant le bit de rang ($L_{min}$ + p), avec p une variable de type nombre entier qui est initialisée à 1 ;

b) si aucune transition n'est détectée, le bit de rang ($L_{min}$ + p) est estimé comme un bit de stop et la trame est traitée comme une trame de ($L_{min}$ + (p- 1)) bits utiles ;

c) si une transition est détectée, le bit de rang ($L_{min}$ + p) est estimé comme un bit utile et :

c-1) si ($L_{min}$ + p) = $L_{max}$, la trame est traitée comme une trame de ($L_{min}$ + p) bits utiles ;

c-2) si ($L_{min}$ + p) < $L_{max}$, on revient à l'étape a) en ayant préalablement incrémenté p de un pour traiter une portion du signal portant le bit suivant.

**7.** Procédé selon la revendication 6, **caractérisé en ce que** l'étape a) comprend elle-même une étape de fenêtrage, limitant à une fenêtre temporelle déterminée la détection d'une éventuelle transition dans la portion du signal portant le bit de rang ($L_{min}$ + p).

**8.** Procédé selon la revendication 7, **caractérisé en ce que** l'étape de fenêtrage met en oeuvre un compteur (31) alimenté par une horloge interne audit circuit, et qui est incrémenté depuis zéro jusqu'à une valeur maximale déterminée, puis décrémenté depuis la valeur maximale déterminée jusqu'à zéro,

et **en ce que** ladite fenêtre temporelle déterminée est définie comme un intervalle de temps pendant lequel la valeur courante du compteur est supérieure ou égale à un seuil prédéterminé.

**9.** Procédé selon la revendication 8, **caractérisé en ce que** ladite valeur maximale déterminée du compteur est une valeur prédéterminée fonction d'une fréquence d'émission et d'un taux de transfert du signal de données.

**10.** Procédé selon la revendication 8, **caractérisé en ce que** ladite valeur maximale déterminée du compteur est lue dans un registre (32) ayant préalablement mémorisé le contenu du compteur lors de la détection d'une transition dans la portion du signal de données portant le bit de rang $L_{min}$.

**11.** Procédé selon l'une quelconque des revendications 8 à 10, **caractérisé en ce que** ledit seuil prédéterminé est égal à la moitié de ladite valeur maximale déterminée du compteur, de sorte que ladite fenêtre temporelle couvre environ 50% d'un temps binaire.

**12.** Procédé selon l'une quelconque des revendications 6 à 11, ladite trame comprenant L bits utiles suivis d'un premier et un second bit de stop, **caractérisé**

**en ce que** l'étape de détection automatique de la longueur de ladite trame comprend en outre une première étape de vérification de la décision, prise lors de l'étape b), de traiter la trame comme une trame de ($L_{min}$ + (p-1)) bits utiles, ladite première étape de vérification consistant à vérifier que le bit de rang ($L_{min}$ + (p+1)) est un second bit de stop.

**13.** Procédé selon l'une quelconque des revendications 6 à 12, **caractérisé en ce que** l'étape de détection automatique de la longueur de la trame comprend en outre une seconde étape de vérification de la décision, prise lors de l'étape c-1), de traiter la trame comme une trame de ($L_{min}$ + p) bits utiles, ladite seconde étape de vérification consistant à vérifier que le bit de rang ($L_{min}$ + (p+1)) est un bit de stop.

**14.** Procédé selon l'une quelconque des revendications 6 à 13, **caractérisé en ce que** : $L_{max}$ = ($L_{min}$ + 1), et **en ce que** l'étape de traitement du bit de rang $L_{max}$ comprend elle-même les étapes successives suivantes :

a') détection d'une éventuelle transition dans une portion du signal portant le bit de rang $L_{max}$ ;

b') si aucune transition n'est détectée, le bit de rang $L_{max}$ est estimé comme un bit de stop et la trame est traitée comme une trame de $L_{min}$ bits utiles ;

c') si une transition est détectée, le bit de rang $L_{max}$ est estimé comme un bit utile et la trame est traitée comme une trame de $L_{max}$ bits utiles.

**15.** Procédé selon l'une quelconque des revendications 1 à 14, **caractérisé en ce que** ledit signal de données est encodé selon un codage de Manchester.

**16.** Produit programme d'ordinateur, **caractérisé en ce qu'**il comprend des instructions de code de programme pour l'exécution des étapes du procédé selon l'une quelconque des revendications 1 à 15, lorsque ledit programme est exécuté sur un ordinateur.

**17.** Moyen de stockage, éventuellement totalement ou partiellement amovible, lisible par un ordinateur, stockant un jeu d'instructions exécutables par ledit ordinateur pour mettre en oeuvre le procédé selon l'une quelconque des revendications 1 à 15.

**18.** Circuit électronique de décodage d'une trame asynchrone biphasé portée par un signal de données encodé et comprenant L bits utiles suivis d'au moins un bit de stop, **caractérisé en ce qu'**il comprend des moyens de détection automatique de la longueur L en bits utiles de la trame de façon à décoder la totalité de la trame, la longueur L de la trame étant variable d'une trame à l'autre et telle que : $L_{min} \leq L \leq L_{max}$, avec $L_{max} = (L_{min} + k)$, où k est un nombre entier prédéterminé supérieur ou égal à 1.

**19.** Circuit électronique de décodage selon la revendication 18, **caractérisé en ce qu'**il comprend en outre des moyens de sélection d'un mode de fonctionnement du circuit électronique parmi au moins deux modes de fonctionnement possibles, en fonction de la longueur L détectée.

**20.** Dispositif de contrôle d'au moins un équipement, **caractérisé en ce qu'**il comprend un circuit électronique de décodage selon l'une quelconque des revendications 18 et 19.

**21.** Dispositif de contrôle selon la revendication 20, **caractérisé en ce que** l'équipement contrôlé est un équipement d'éclairage.

RxD → **DECODEUR** ← L_CLK (12)
11
→ DATA
n (13)
14

## Fig. 1

**A** Comptage
cnt=N/2

**X** Détection du 16ème bit de donnée

cnt=cnt+1

donnée sur RxD

**B** Ouverture de la fenêtre de détection

cnt=cnt+1

pas de donnée sur RxD et le compteur à atteint sa valeur maximum

donnée sur RxD

**C** Attente du 17ème bit (décomptage)

cnt=cnt-1

échantillonage du 17ème bit

**D** Détection du 17ème bit de donnée

cnt=cnt-1

cnt=N/2

**E** Echantillonage du bit de stop

cnt=cnt-1

**G** Vers détedtion 1er stop si 17 bits 2ème stop si 16 bits

**F** Fin de décomptage

cnt=cnt-1

## Fig. 4

Fig. 3

initialisation avec fonctionnement
dans le mode normal — 21

détection automatique de la
longueur L de la trame courante
et décodage de toute la trame — 22

23

L = 17    L = 16 ou 17
bits utiles ?    L = 16

passage au mode de test pour le
traitement de la trame suivante

maintien du mode normal pour
le traitement de la trame suivante

25    24

Fig. 2

transition
17$^{\text{ème}}$ bit utile

RxD

Cnt

N

N/2      N/2

précision de +/-50%

Ⓐ   Ⓑ   Ⓒ Ⓓ   Ⓕ

Fig. 7

1$^{\text{er}}$ bit de stop

RxD

2$^{\text{nd}}$ bit de stop

Cnt

N

N/2      N/2

précision de +/-50%

Ⓔ

Ⓐ   Ⓑ   Ⓒ   Ⓕ

Fig. 8

Fig. 5

tclkmanchester 51
RxD 52

bit de start | bit utile 1 | bit utile 2 | bit utile 3 | bit utile 15 | bit utile 16 | bit utile 17 | 1er bit de stop | 2nd bit de stop

Cnt (valeur du compteur K) 53

msize 54
16    16

data_count 55
0    1    2    15    16    17    0

Detect Window (fenêtre de détection) 56

clk_out 57

EP 1 533 907 A1

14

Fig. 6

**Office européen des brevets**

# RAPPORT DE RECHERCHE EUROPEENNE

Numéro de la demande

EP 04 36 4070

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| X | US 5 754 764 A (WATERSON KENT BRUCE ET AL) 19 mai 1998 (1998-05-19) | 1-19 | H03M5/12 |
| A | * colonnes 126,130; revendication 7; figures 3.23,3.26 * | 20,21 | |
| X | SASTRY R ET AL: "A low cost optical slotted ring network for RS-232C based communications" TENCON 1989, FOURTH IEEE REGION 10 INTERNATIONAL CONFERENCE, 22 novembre 1989 (1989-11-22), pages 646-649, XP010087882 | 1-19 | |
| A | * page 647, colonne de droite - page 648, colonne de droite * | 20,21 | |
| A | EP 0 245 972 A (AMERICAN TELEPHONE & TELEGRAPH) 19 novembre 1987 (1987-11-19) * page 5, colonne de droite - page 6, colonne de droite * | 1-22 | |
| A | US 4 241 398 A (CARLL RICHARD T) 23 décembre 1980 (1980-12-23) * colonnes 4,10; figure 8 * | 1-22 | **DOMAINES TECHNIQUES RECHERCHES (Int.Cl.7)** H03M |

Le présent rapport a été établi pour toutes les revendications

| Lieu de la recherche | Date d'achèvement de la recherche | Examinateur |
|---|---|---|
| Munich | 16 mars 2005 | Holzlöhner, R |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
 
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 04 36 4070

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

16-03-2005

| Document brevet cité au rapport de recherche | | Date de publication | Membre(s) de la famille de brevet(s) | | Date de publication |
|---|---|---|---|---|---|
| US 5754764 | A | 19-05-1998 | AUCUN | | |
| EP 0245972 | A | 19-11-1987 | US | 4740992 A | 26-04-1988 |
| | | | CA | 1271536 A1 | 10-07-1990 |
| | | | CN | 87103125 A ,B | 20-01-1988 |
| | | | DE | 3786950 D1 | 16-09-1993 |
| | | | DE | 3786950 T2 | 23-12-1993 |
| | | | EP | 0245972 A2 | 19-11-1987 |
| | | | JP | 1839585 C | 25-04-1994 |
| | | | JP | 5052105 B | 04-08-1993 |
| | | | JP | 62278842 A | 03-12-1987 |
| | | | KR | 9504876 B1 | 15-05-1995 |
| US 4241398 | A | 23-12-1980 | AUCUN | | |

EPO FORM P0460

Pour tout renseignement concernant cette annexe : voir Journal Officiel de l'Office européen des brevets, No.12/82